# EUROPEAN PATENT APPLICATION

(11) **EP 4 726 786 A1**
(43) Date of publication of application: **15.04.2026**
(21) Application number: 23940401.5
(22) Date of filing: 27.10.2023
(51) Int. Cl.: H01L 33/52, H01L 25/075

(54) **SMD LED DISPLAY DEVICE AND TERMINAL DEVICE**

(30) Priority: 08.06.2023 CN 202310676756
(71) Applicant: Shenzhen Infiled Electronics Co., Ltd, Shenzhen, Guangdong 518108 (CN)
(72) Inventor: ZHANG, Jian, Shenzhen, Guangdong 518108 (CN); HAO, Zongchao, Shenzhen, Guangdong 518108 (CN); GUO, Yang, Shenzhen, Guangdong 518108 (CN)
(74) Representative: Cabinet Chaillot
(86) International application number: PCT/CN2023/127056
(87) International publication number: WO 2024/250525

(57) **Abstract**

An SMD LED display device, comprises: a substrate, a display unit being arranged on the substrate, the display unit including at least one pixel unit, the pixel unit including RGB trichromatic chips, and the RGB trichromatic chips including a red light-emitting chip, a blue light-emitting chip and a green light-emitting chip and an encapsulant, covering a periphery of the pixel unit. A first distance from the red light-emitting chip on the pixel unit to a nearest edge of the encapsulant, a second distance from the blue light-emitting chip on the pixel unit to a nearest edge of the encapsulant, and a third distance from the green light-emitting chip on the pixel unit to a nearest edge of the encapsulant are equal. the light-emitting angles of the light-emitting chips in different colors may be kept uniform, thus reducing the color cast when a display screen is watched from the top or bottom.

## Description

### FIELD

The invention relates to the technical field of LED displays, in particular to an SMD LED display device.

### BACKGROUND

Existing LED display screens are assembled by splicing numerous LED modules arranged according to specific pixel pitches, with the trichromatic chips distributed in a line. Existing LED display screens have the following defects: when users watch the display screens from the front, the left and the right, there is not a large difference in color temperatures; however, when users watch the display screens from the top or the bottom, there will be a large difference in color temperatures, leading to a color cast from different views of the display screens.

### SUMMARY

The embodiments of the invention provide an SMD LED display device capable of reducing the color cast of surface-mount device (SMD) light emitting diode (LED) display devices.

An SMD LED display device according to one aspect of the present invention, comprises:
a substrate, wherein a display unit is arranged on the substrate, the display unit comprises at least one pixel unit, the pixel unit comprises RGB trichromatic chips, and the RGB trichromatic chips comprise a red light-emitting chip, a blue light-emitting chip and a green light-emitting chip; and
an encapsulant, covering a periphery of the pixel unit;
wherein, a first distance from the red light-emitting chip on the pixel unit to a nearest edge of the encapsulant, a second distance from the blue light-emitting chip on the pixel unit to a nearest edge of the encapsulant, and a third distance from the green light-emitting chip on the pixel unit to a nearest edge of the encapsulant are equal.

Optionally, the encapsulant is formed by compression molding, and the red light-emitting chip, the blue light-emitting chip and the green light-emitting chip are distributed on the substrate in an equilateral triangular configuration.

Optionally, the SMD LED display device comprises multiple said display units, wherein each of the display units comprises at least one said pixel unit, and a lateral distance between the light-emitting chips with the same color on two laterally adjacent said pixel units is equal to a longitudinal distance between the light-emitting chips with the same color on two longitudinally adjacent said pixel units.

Optionally, the SMD LED display device comprises multiple said display units, wherein each of the display units comprises one said pixel unit, and a lateral distance between the light-emitting chips with the same color on two laterally adjacent said display units is equal to a longitudinal distance between the light-emitting chips with the same color on two longitudinally adjacent said display units.

Optionally, the display unit comprises one said pixel unit, the pixel unit further comprises a red anode pin, a blue anode pin, a green anode pin and a common cathode pin; or, the pixel unit further comprises a red cathode pin, a blue cathode pin, a green cathode pin and a common anode pin.

Optionally, the display unit comprises a first pixel unit and a second pixel unit, and the display unit comprises six pins or eight pins;
a distance from a red light-emitting chip of the first pixel unit to a red light-emitting chip of the second pixel unit, a distance from a blue light-emitting chip of the first pixel unit to a blue light-emitting chip of the second pixel unit, and a distance from a green light-emitting chip of the first pixel unit to a green light-emitting chip of the second pixel unit are equal.

Optionally, a distance from one chip of the RGB trichromatic chips of the first pixel unit to a nearest first edge of the encapsulant, a distance from said chip of the first pixel unit to a nearest second edge of the encapsulant, distances from the other two chips of the RGB trichromatic chips of the first pixel unit to their respective nearest edges of the encapsulant, a distance from one chip of the RGB trichromatic chips of the second pixel unit to a nearest first edge of the encapsulant, a distance from said chip of the second pixel unit to a nearest second edge of the encapsulant, and distances from the other two chips of the RGB trichromatic chips of the second pixel unit to their respective nearest edges of the encapsulant are equal.

Optionally, the RGB trichromatic chips adopt front-side mounting, the display unit comprises six pins, and the six pins comprise two common anode pins, a red common cathode pin, a blue common cathode pin and a red common cathode pin; or,
the RGB trichromatic chips adopt front-side mounting, the display unit comprises six pins, and the six pins comprise two common cathode pins, a red common anode pin, a blue common anode pin and a green common anode pin; or,
the RGB trichromatic chips adopt front-side mounting, the display unit comprises eight pins, and the eight pins comprise two common pins, three pins respectively connected to a first red light-emitting chip, a first blue light-emitting chip and a first green light-emitting chip, and three chips respectively connected to a second red light-emitting chip, a second blue light-emitting chip and a second green light-emitting chip; and the common pins and the pins connected to the RGB trichromatic chips have opposite polarities.

Optionally, the RGB trichromatic chips adopt flip-chip mounting, the display unit comprises six pins, and the six pins comprise two common anode pins, a red common cathode pin, a blue common cathode pin and a green common cathode pin; or,
the RGB trichromatic chips adopt flip-chip mounting, the display unit comprises eight pins, and the eight pins comprise two common anode pins, a first red cathode pin connected to the red light-emitting chip of the first pixel unit, a first blue cathode pin connected to the blue light-emitting chip of the first pixel unit, a first green cathode pin connected to the green light-emitting chip of the first pixel unit, a second red cathode pin connected to the red light-emitting chip of the second pixel unit, a second blue cathode pin connected to the blue light-emitting chip of the second pixel unit, and a second green cathode pin connected to the green light-emitting chip of the second pixel unit.

Optionally, the display unit comprises a first pixel unit, a second pixel unit, a third pixel unit and a fourth pixel unit, the first pixel unit is adjacent to the second pixel unit, the third pixel unit is adjacent to the fourth pixel unit, and the display unit comprises eight pins or sixteen pins;
a distance from a red light-emitting chip of the first pixel unit to a red light-emitting chip of the second pixel unit, a distance from a blue light-emitting chip of the first pixel unit to a blue light-emitting chip of the second pixel unit, and a distance from a green light-emitting chip of the first pixel unit to a green light-emitting chip of the second pixel unit are equal;
a distance from a red light-emitting chip of the third pixel unit to a red light-emitting chip of the fourth pixel unit, a distance from a blue light-emitting chip of the third pixel unit to a blue light-emitting chip of the fourth pixel unit, and a distance from a green light-emitting chip of the third pixel unit to a green light-emitting chip of the fourth pixel unit are equal.

The embodiments of the invention have at least the following beneficial effects:
As can be seen, the SMD LED display device provided by the embodiments of the invention includes a substrate, a display unit being arranged on the substrate, the display unit including at least one pixel unit, the pixel unit including RGB trichromatic chips, and the RGB trichromatic chips including a red light-emitting chip, a blue light-emitting chip and a green light-emitting chip; and a encapsulant covering a periphery of the pixel unit. A first distance from the red light-emitting chip on the pixel unit to a nearest edge of the encapsulant, a second distance from the blue light-emitting chip on the pixel unit to a nearest edge of the encapsulant, and a third distance from the green light-emitting chip on the pixel unit to a nearest edge of the encapsulant are equal, such that the light-emitting angles of the chips in different colors of the RGB trichromatic chips may be kept consistent, thus reducing the color cast when a display screen is watched from the top or the bottom.

### BRIEF DESCRIPTION OF THE DRAWINGS

To more clearly explain the technical solutions in the embodiments of the invention or the prior art, drawings used for describing the embodiments of the invention or the prior art are briefly introduced below. Obviously, the drawings described below merely illustrate some embodiments of the invention, and those ordinarily skilled in the art may obtain other drawings according to the following ones without creative labor.
FIG. 1 is a schematic diagram of different color temperatures of a display screen, watched from different views, of a display in the prior art according to an embodiment of the invention;
FIG. 2 is a schematic diagram of an SMD LED display according to an embodiment of the invention;
FIG. 3 is a schematic diagram of an SMD LED display according to an embodiment of the invention;
FIG. 4 is a schematic diagram of an SMD LED display according to an embodiment of the invention;
FIG. 5 is a schematic diagram of an SMD LED display before an encapsulant is cut according to an embodiment of the invention;
FIG. 6 is a schematic diagram of an SMD LED display after an encapsulant is cut according to an embodiment of the invention;
FIG. 7 is a schematic diagram of a display unit with one pixel unit according to an embodiment of the invention;
FIG. 8 is a schematic diagram of a display unit with one pixel unit according to an embodiment of the invention;
FIG. 9 is a schematic diagram of a display unit with two pixel units according to an embodiment of the invention;
FIG. 10 is a schematic circuit diagram of FIG. 9 according to an embodiment of the invention;
FIG. 11 is a schematic diagram of a display unit with two pixel units according to an embodiment of the invention;
FIG. 12 is a schematic circuit diagram of FIG. 11 according to an embodiment of the invention;
FIG. 13 is a schematic diagram of a display unit with two pixel units according to an embodiment of the invention;
FIG. 14 is a schematic circuit diagram of FIG. 13 according to an embodiment of the invention;
FIG. 15 is a schematic diagram of a display unit with two pixel units according to an embodiment of the invention;
FIG. 16 is a schematic circuit diagram of FIG. 15 according to an embodiment of the invention;
FIG. 17 is a schematic diagram of a display unit with two pixel units according to an embodiment of the invention;
FIG. 18 is a schematic circuit diagram of FIG. 17 according to an embodiment of the invention;
FIG. 19 is a schematic diagram of a display unit with two pixel units according to an embodiment of the invention;
FIG. 20 is a schematic circuit diagram of FIG. 17 according to an embodiment of the invention;
FIG. 21 is a schematic diagram of a display unit with four pixel units according to an embodiment of the invention;
FIG. 22 is a schematic diagram of a display unit with four pixel units according to an embodiment of the invention.

### DESCRIPTION OF THE EMBODIMENTS

The technical solutions in the embodiments of the invention are clearly and completely described below in conjunction with the drawings in the embodiments of the invention. Obviously, the embodiments in the following description are merely illustrative ones, and are not all possible ones of the invention. All other embodiments obtained by those ordinarily skilled in the art based on the following ones without creative labor should also fall within the protection scope of the invention.

Terms such as "first" and "second" in the description, claims and drawings of the invention are used for distinguishing different objects rather than describing a specific sequence. In addition, terms "comprise" and "provided with" and any variants thereof are intended to indicate non-exclusive inclusion.

"Embodiment" mentioned in the invention means that specific features, structures and characteristics described in conjunction with said embodiment may be included in at least one embodiment of the invention. "Embodiment" mentioned in different positions of the description does not definitely refer to the same embodiment and is not an independent or standby embodiment exclusive with other embodiments. Those skilled in the art may explicitly or implicitly understand that the embodiments described here may be combined with other embodiments.

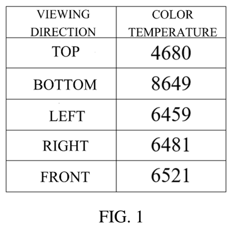

As shown in FIG. 1 which is a schematic diagram of color temperatures of a display screen, with trichromatic chips arranged in a line, when watched from the top, the bottom, the left, the right and the front, there is an obvious difference in color temperatures from different viewing directions, and there is a great difference in color temperatures when the display screen is watched from the top and the bottom.

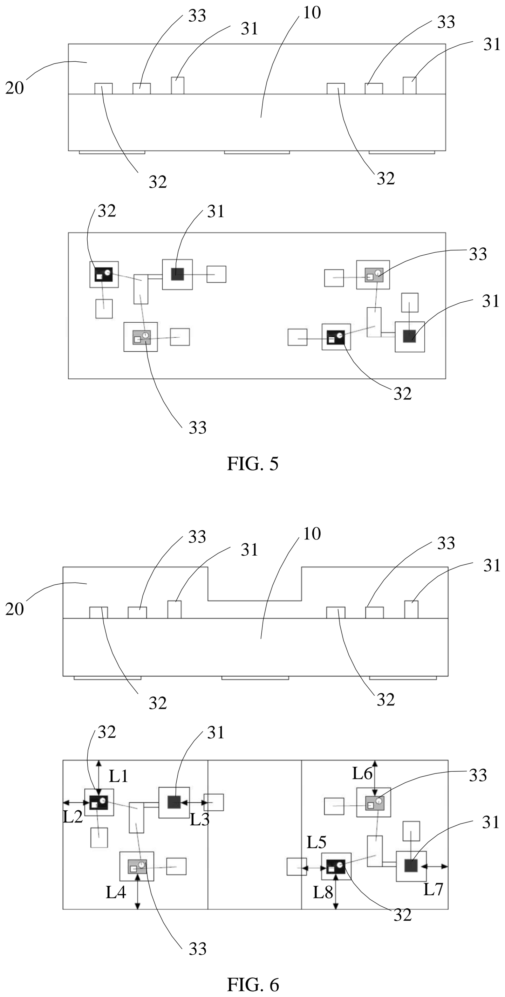

Referring to FIGS. 2-15, FIGS. 2-4 are schematic structural diagrams of an SMD LED display device according to an embodiment of the invention, and FIGS. 5-15 are schematic structural diagrams of a display unit. The device may include a plurality of display units. The SMD LED display device includes a substrate, wherein a display unit 30 is arranged on the substrate 10, the display unit 30 includes at least one pixel unit, the pixel unit includes RGB trichromatic chips, and the RGB trichromatic chips includes a red light-emitting chip 31, a blue light-emitting chip 32 and a green light-emitting chip 33; and an encapsulant 20 covering a periphery 30 of the pixel unit. A first distance from the red light-emitting chip 31 on the pixel unit to a nearest edge of the encapsulant 20, a second distance from the blue light-emitting chip 32 on the pixel unit to a nearest edge of the encapsulant 20 and a third distance from the green light-emitting chip 33 on the pixel unit to a nearest edge of the encapsulant are equal.

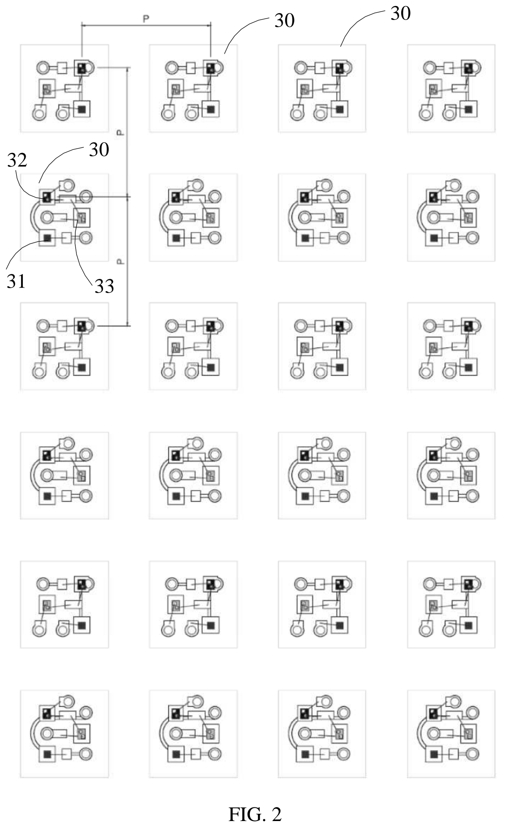

As shown in FIG. 2, the display unit 30 may include one pixel unit, and the pixel unit includes RGB trichromatic chips.

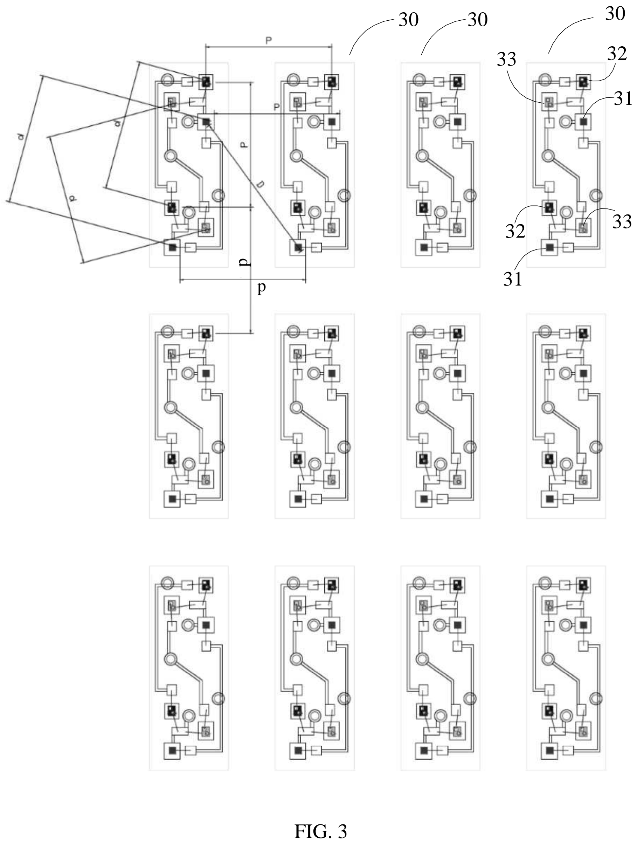

As shown in FIG. 3, the display unit 30 may include two pixel units, and each pixel unit includes RGB trichromatic chips.

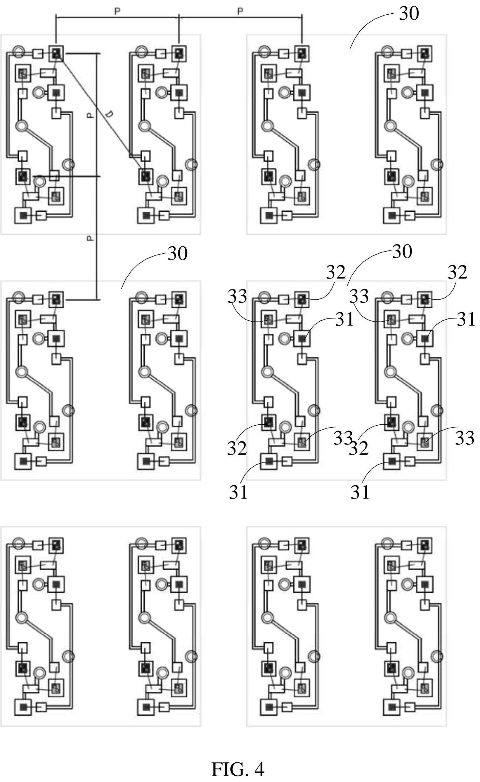

As shown in FIG. 4, the display unit 30 may include four pixel unit, and each pixel unit includes RGB trichromatic chips.

Wherein, as shown in FIG. 5, the substrate of the SMD LED display device is a BT (Bismaleimide Triazine) board of a chip structure without reflector cup. The BT board is black, grey or white. Pins and bonding pads of the display device are gold-plated or silver-plated. The outline dimension of the substrate and the number of the pins are not limited.

In the application, to guarantee a good uniformity of light-emitting angles of the red light-emitting chip, the blue light-emitting chip and the green light-emitting chip of the RGB trichromatic chips, the distances from the RGB trichromatic chips to the edges of the encapsulant of the display device are set to be the same, as shown in FIGS. 5-6.

The material of the encapsulant comprise any one of epoxy resin, silicone resin and epoxy-modified material in solid or liquid form.

In the manufacturing process of the SMD LED display device, an epoxy glue is compression molded, and then, an epoxy resin encapsulant is cut to ensure that the distances from the RGB trichromatic chips to the edges of the encapsulant are equal. Referring to FIG. 5 which is a schematic diagram of the display device after the glue is poured and before the encapsulant is cut, the upper diagram in FIG. 5 is a front view, which illustrates the substrate 10, the encapsulant 20 and the RGB trichromatic chips, and the lower diagram is a top view, which illustrates the RGB trichromatic chips.

Referring to FIG. 6, which is a schematic diagram of the display device after the encapsulant is cut, the upper diagram in FIG. 6 is a front view, which illustrates the substrate 10, the encapsulant 20 and the RGB trichromatic chips, and the lower diagram is a top view, which illustrates the RGB trichromatic chips. After being formed by compression molding from the glue, the encapsulant is cut, and the distances from the RGB trichromatic chips to the nearest edges of the encapsulant are the same, that is, L1=L2=L3=L4=L5=L6=L7=L8, such that the RGB trichromatic chips exhibit high light-emitting angle uniformity, thereby reducing the color cast in the display device.

Optionally, the encapsulant 20 is formed by compression molding, and the red light-emitting chip 31, the blue light-emitting chip 32 and the green light-emitting chip 33 are distributed on the substrate 10 in an equilateral triangular configuration.

In the application, the red light-emitting chip, the blue light-emitting chip and the green light-emitting chip are distributed on the substrate in the equilateral triangular configuration, such that the uniformity of the light-emitting angles of chips in different colors of the RGB trichromatic chips may be improved, thereby reducing the color cast when a display screen is watched from the top or the bottom and optimizing the display effect of the display device.

Optionally, the RGB trichromatic chips are welded to a bonding pad on the substrate by means of any one of a gold wire, an alloy wire, a copper wire and a solder paste.

Wherein, for the RGB trichromatic chips adopting flip-chip mounting, solder paste bonding may be employed to establish electrical connection.

Optionally, as shown in FIG. 2, the SMD LED display device includes a plurality of display units 30, wherein each display unit 30 includes a pixel unit, a lateral distance between light-emitting chips in the same color on two laterally adjacent display units 30 is equal to a longitudinal distance of light-emitting chips in the same color on two longitudinally adjacent display units 30.

By keeping the lateral distance and the longitudinal distance between light-emitting chips in the same color of adjacent display units, the uniformity of the light-emitting angles is high, thus reducing the color cast of the display device.

Specifically, as shown in FIG. 2, for laterally adjacent display units 30, for example, the display unit in the first row and the first column and the display unit in the first row and the second column, a lateral distance between blue light-emitting chips is p. For two longitudinally adjacent display units 30, for example, the display unit in the first column and the first row, the display unit in the first column and the second row and the display unit in the first column and the third row, a lateral distance between a blue light-emitting chip in the first column and the first row and a blue light-emitting chip in the first column and the second row and a lateral distance between the blue light-emitting chip in the first column and the second row and a blue light-emitting chip in the first column and the third row are both p. In addition, a lateral distance between red light-emitting chips on any two laterally adjacent display units 30 and a longitudinal distance between red light-emitting chips on any two longitudinally adjacent display units 30 are equal and are both p. A lateral distance between green light-emitting chips on any two laterally adjacent display units 30 and a longitudinal distance between green light-emitting chips on any two longitudinally adjacent display units 30 are equal and are both p.

Optionally, as shown in FIGS. 2-4, the SMD LED display device includes a plurality of display units, wherein each display unit includes at least one pixel unit, and a lateral distance between light-emitting chips in the same color on two laterally adjacent pixel units is equal to a longitudinal distance between light-emitting chips in the same color on two longitudinally adjacent pixel units.

Specifically, the two laterally adjacent pixel units may be two adjacent pixel units on the same display unit or two adjacent pixel units on two adjacent display units. By keeping the lateral distance and longitudinal distance between the light-emitting chips in the same color on adjacent pixel units equal, the uniformity of light-emitting angles is high, thereby reducing the color cast of the display.

As shown in FIG. 3, with the display unit in the first row and the first column and the display unit in the first row and the second column as an example, in two laterally adjacent pixel units, a lateral distance between blue light-emitting chips of is p, a lateral distance between red light-emitting chips is p, and a lateral distance between green light-emitting chips is p. With the display unit in the first column and the first row and the display unit in the first column and the second row as an example, each display unit in the first column includes two longitudinally adjacent pixel units, a longitudinal distance between blue light-emitting chips of the two pixel units is p, and a longitudinal distance between red light-emitting chips of the two pixel units is p; and the lower pixel unit in the display unit in the first column and the first row is adjacent to the upper pixel unit in the display unit in the first column and the second row, the two adjacent pixel units are from different display units, a longitudinal distance of blue light-emitting chips of the two adjacent pixel units is p, and a longitudinal distance between red light-emitting chips of the two adjacent pixel units is p.

As shown in FIG. 4, with the display unit in the first row and the first column and the display unit in the first row and the second column as an example, the display unit in the first row and the first column includes laterally adjacent pixel units, and in the laterally adjacent pixel units, a lateral distance between blue light-emitting chips is p, a lateral distance between red light-emitting chips is p, and a lateral distance between green light-emitting chips is p. The display unit in the first row and the first column and the display unit in the first row and the second column include laterally adjacent pixel units, and in the laterally adjacent pixel units, a lateral distance between blue light-emitting chips is p, a lateral distance between red light-emitting chips is p, and a lateral distance between green light-emitting chips is p.

In addition, with the display unit in the first column and the first row and the display unit in the first column and the second row an example, each display unit in the first column includes two longitudinally adjacent pixel units, and in the two longitudinally adjacent pixel units, a longitudinal distance between blue light-emitting chips is p, a distance between red light-emitting chips is p, and a longitudinal distance between green light-emitting chips is p; and the lower pixel unit in the display unit in the first column and the first row is adjacent to the upper pixel unit in the display unit in the first column and the second row, the two adjacent pixel units are from different display units, and in the two adjacent pixel units, a longitudinal distance between blue light-emitting chips is p, a longitudinal distance between red light-emitting chips is p, and a longitudinal distance between green light-emitting chips is p.

In FIG. 3, d is the distance between light-emitting chips in the same color in the adjacent pixel units. For example, in two adjacent pixel units in one display unit, the distance between red light-emitting chips, the distance between blue light-emitting chips and the distance between green light-emitting chips are all d. In FIGS. 3 and 4, D is the distance between light-emitting chips in the same color in two nonadjacent pixel units. For example, as shown in FIG. 4, in one display unit, the distance between red light-emitting chips in two nonadjacent pixel units is D.

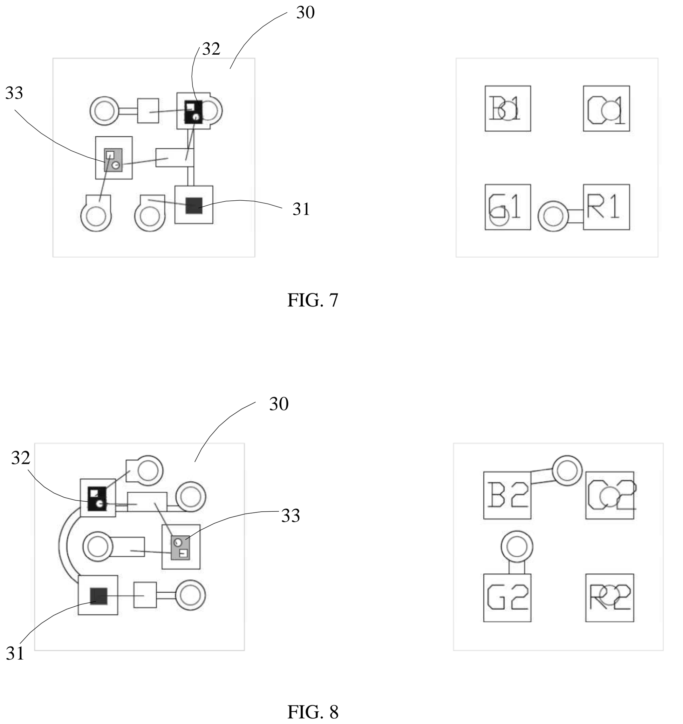

In one embodiment, as shown in FIG. 7, in which the left diagram is a schematic structural diagram of the display unit and the right diagram is a schematic structural diagram of pins of the display unit, the display unit includes one pixel unit, the pixel unit further includes a red anode pin R1, a blue anode pin B1, a green anode pin G1 and a common cathode pin C1.

In one embodiment, as shown in FIG. 8, in which the left diagram is a schematic structural diagram of the display unit and the right diagram is a schematic diagram of pins of the display unit, the display unit includes one pixel unit, and the pixel unit further includes a red cathode pin R2, a blue cathode pin B2, a green cathode pin G2 and a common anode pin C2.

Optionally, in some embodiments, as shown in FIGS. 3, 9 and 10, the display unit 30 includes a first pixel unit and a second pixel unit, and the display unit 30 includes six pins or eight pins.

The distance from the red light-emitting chip 31 of the first pixel unit to the red light-emitting chip 31 of the second pixel unit, the distance from the blue light-emitting chip 32 of the first pixel unit to the blue light-emitting chip 32 of the second pixel unit and the distance from the green light-emitting chip 33 of the first pixel unit to the green light-emitting chip 33 of the second pixel unit are equal.

As shown in FIG. 3, the display unit includes two pixel units, and the distance from the red light-emitting chip 31 in one of the two pixel units to the red light-emitting chip 31 in the other pixel unit, the distance from the blue light-emitting chip 32 in one of the two pixel units to the blue light-emitting chip 32 in the other pixel unit, and the distance from the green light-emitting chip 33 in one of the two pixel units to the green light-emitting chip 33 in the other pixel unit are equal and are all d.

By setting the distances between chips in the same color in the two pixel units in the display unit to be equal, the light-emitting angles of the chips in different colors of the RGB trichromatic chips are kept uniform, thus reducing the color cast when a display screen is watched from the top or the bottom, and optimizing the display effect of the display device.

Optionally, as shown in FIG. 6, the distances from one chip of the RGB trichromatic chips of the first pixel unit to a nearest first edge of the encapsulant 20 and to a nearest second edge of the encapsulant 20, the distances from the other two chips of the RGB trichromatic chips of the first pixel unit to the nearest edges of the encapsulant 20, the distances from one chip of the RGB trichromatic chips of the second pixel unit to the nearest first edge of the encapsulant and to the nearest second edge of the encapsulant, and the distances from the other two chips of the RGB trichromatic chips of the second pixel unit to the nearest edges of the encapsulant are equal.

As shown in FIG. 6, the distance L1 from the blue light-emitting chip 32 of the RGB trichromatic chips of the first pixel unit to the nearest first edge of the encapsulant 20, the distance L2 from the blue light-emitting chip 32 of the RGB trichromatic chips of the first pixel unit to the nearest second edge of the encapsulant 20, the distances L3 and L4 from the other two chips (i.e., the red light-emitting chip 31 and the green light-emitting chip 33) of the RGB trichromatic chips of the first pixel unit to the nearest edges of the encapsulant 20, the distance L5 from the blue light-emitting chip 32 of the RGB trichromatic chips of the second pixel unit to the nearest first edge of the encapsulant 20, the distance L8 from the blue light-emitting chip 32 of the RGB trichromatic chips of the second pixel unit to the nearest second edge of the encapsulant 20, and the distances L7 and L6 from the other two chips (i.e., the red light-emitting chip 31 and the green light-emitting chip 33) of the RGB trichromatic chips of the second pixel unit to the nearest edges of the encapsulant are equal, that is, L1=L2=L3=L4=L5=L6=L7=L8, such that the uniformity of the light-emitting angles of the display is high, thus reducing the color cast of the display device.

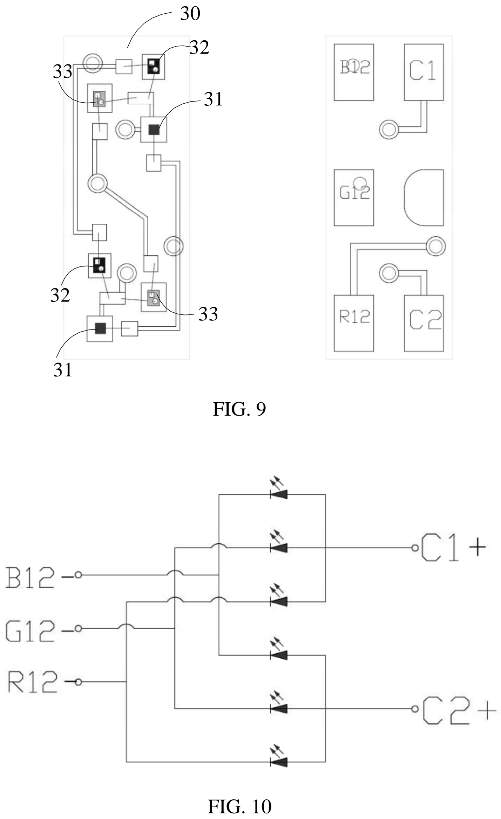

In one embodiment, as shown in FIGS. 9 and 10, the left diagram of FIG. 9 being a schematic structural diagram of the display unit and the right diagram being a schematic structural diagram of pins of the display unit, FIG. 10 being a schematic circuit diagram of the embodiment shown in FIG. 9, the display unit includes two pixel units, the RGB trichromatic chips adopt front-side mounting, the display unit includes six pins, and the six pins include two common anode pins C1+ and C2+, a red common cathode pin R12-, a blue common cathode pin B12- and a green common cathode pin G12-.

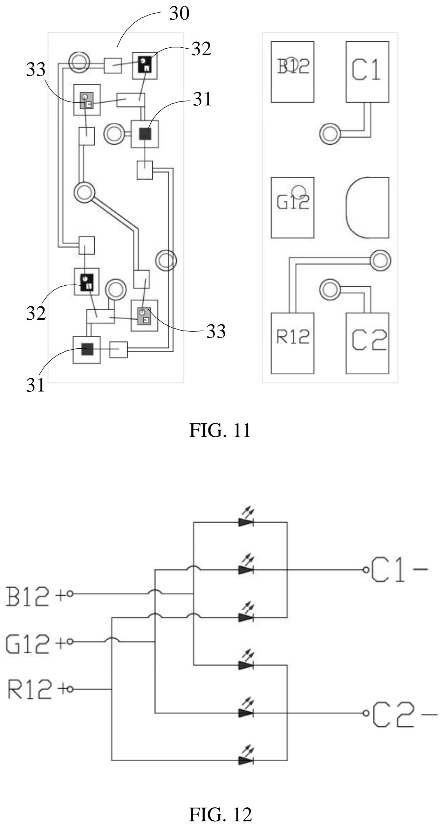

In one embodiment, as shown in FIGS. 11 and 12, the left diagram of FIG.11 being a structural diagram of the display unit and the right diagram being a schematic structural diagram of pins of the display unit, FIG. 12 being a schematic circuit diagram of the embodiment shown in FIG. 11, the display unit includes two pixel units, the RGB trichromatic chips adopt front-side mounting, the display unit includes six pins, and the six pins include two common cathode pins C1- and C2-, a red common anode pin R12+, a blue common anode pin B12+ and a green common anode pin G12+.

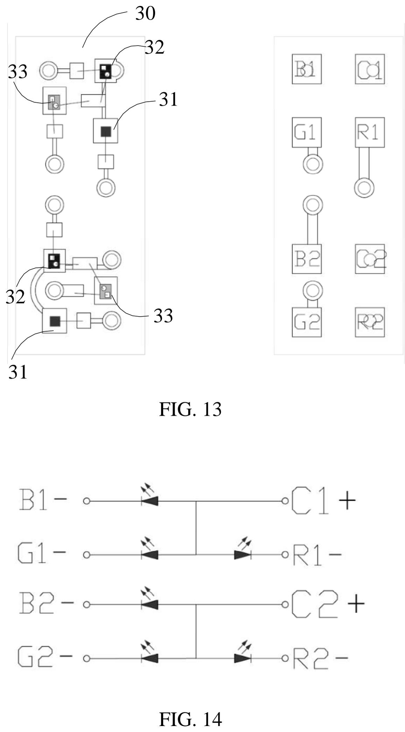

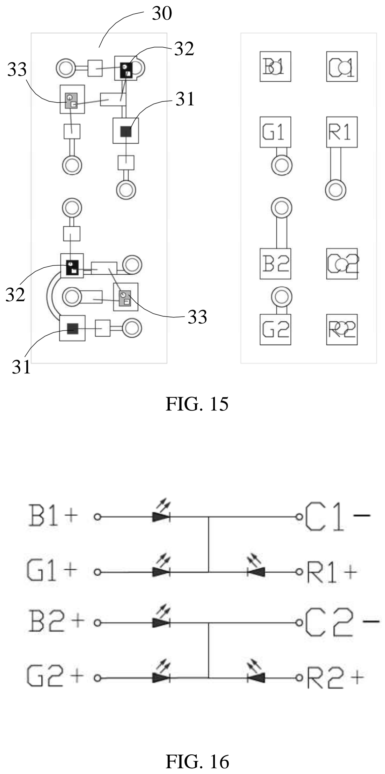

In one embodiment, as shown in FIGS. 13-16, left diagram in FIG. 13 being a schematic structural diagram of the display unit and the right diagram being a schematic structural diagram of pins of the display unit, FIG. 14 being a schematic circuit diagram of the embodiment shown in FIG. 13, the display unit includes two pixel units, the RGB trichromatic chips adopt front-side mounting, the display unit includes eight pins, and the eight pins include two common pins C1 and C2, three pins R1, B1 and G1 respectively connected to a first red light-emitting chip, a first blue light-emitting chip and a first green light-emitting chip, and three pins R2, B2 and G2 respectively connected to a second red light-emitting chip, a second blue light-emitting chip and a second green light-emitting chip; and the polarity of the common pins is opposite to the polarity of the pins connected to the RGB trichromatic chips. As shown in FIGS. 13 and 14, the common pins are anode pins, and the pins corresponding to the RGB trichromatic chips are cathode pins. As shown in FIGS. 15 and 16, the left diagram of FIG. 15 being a schematic structural diagram of the display unit and the right diagram being a schematic structural diagram of pins of the display unit, FIG. 16 being a schematic circuit diagram of the embodiment shown in FIG. 15, the display unit includes two pixel units, common pins are cathode pins C1- and C2-, and pins corresponding to the two RGB trichromatic chips are anode pins R1+, B1+, G1+, R2+, B2+ and G2+.

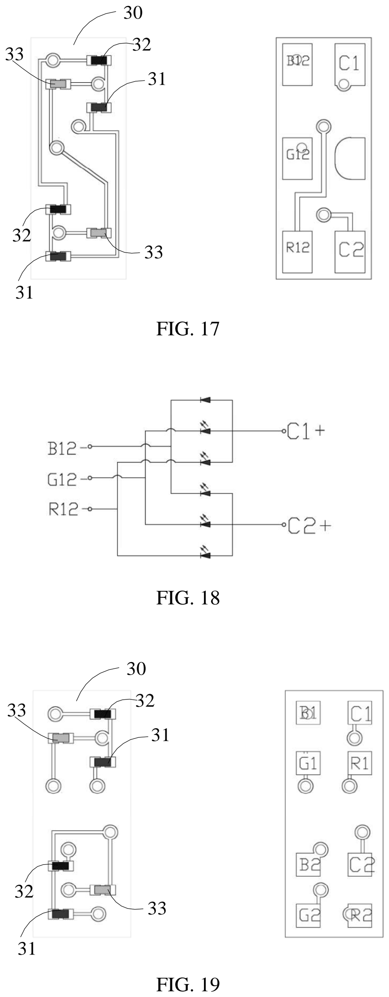

In one embodiment, as shown in FIGS. 17 and 18, the left diagram of FIG. 17 being a schematic structural diagram of a display unit and the right diagram is a schematic structural diagram of pins of the display unit, FIG. 18 being a schematic circuit diagram of the embodiment shown in FIG. 17, the display unit includes two pixel units, the RGB trichromatic chips adopt flip-chip mounting, the display unit includes sixth pin, and the six pins include two common anode pins C1+ and C2+, a red common cathode pin R12, a blue common cathode pin B12- and a green common cathode pin G12-.

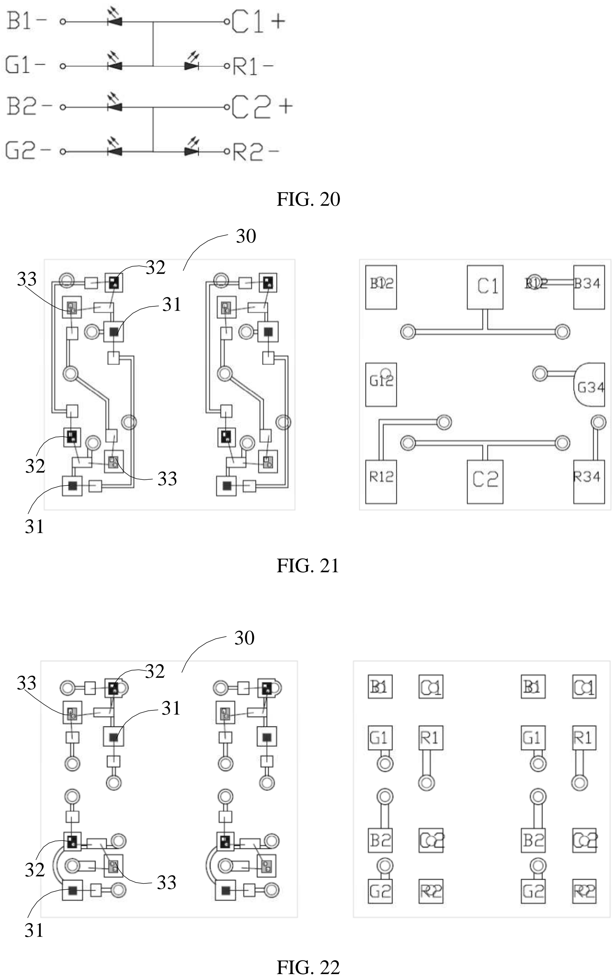

In one embodiment, as shown in FIGS. 19 and 20, the left diagram of FIG. 19 being a schematic structural diagram of the display unit and the right diagram is a schematic structural diagram of pins of the display unit, FIG. 20 being a schematic circuit diagram of the embodiment shown in FIG. 19, the display unit includes two pixel units, the RGB trichromatic chips adopt flip-chip mounting, the display unit includes eight pins, the eight pins include two common anode pins C1+ and C2+, a first red cathode pins R1-, a first blue cathode pin B1- and a first green cathode chip G1- respectively connected to the red light-emitting chip, the blue light-emitting chip and the green light-emitting chip of the first pixel unit, and a second red cathode pins R2-, a second blue cathode pin B2- and a second green cathode chip G2- respectively connected to the red light-emitting chip, the blue light-emitting chip and the green light-emitting chip of the second pixel unit.

Optionally, in some embodiments, as shown in FIGS. 4, 21 and 22, the display unit includes a first pixel unit, a second pixel unit, a third pixel unit and a fourth pixel unit, wherein the first pixel unit is adjacent to the second pixel unit, the third pixel unit is adjacent to the fourth pixel unit, and the display unit includes eight or sixteen pins.

The distance from the red light-emitting chip 31 of the first pixel unit to the red light-emitting chip 31 of the second pixel unit, the distance from the blue light-emitting chip 32 of the first pixel unit to the blue light-emitting chip 32 of the second pixel unit and the distance from the green light-emitting chip 33 of the first pixel unit to the green light-emitting chip 33 of the second pixel unit are equal and are all d.

The distance from the red light-emitting chip 31 of the third pixel unit to the red light-emitting chip 31 of the fourth pixel unit, the distance from the blue light-emitting chip 32 of the third pixel unit to the blue light-emitting chip 32 of the fourth pixel unit and the distance from the green light-emitting chip 33 of the third pixel unit to the green light-emitting chip 33 of the fourth pixel unit are equal and are all d.

By setting the distances between chips in the same color of two adjacent pixel units to be equal, the light-emitting angles of the chips in different colors of the RGB trichromatic chips may be kept consistent, thus reducing the color cast when the display screen is watched from the top or the bottom and optimizing the display effect of the display.

As shown in FIG. 21, in which the left diagram is a schematic structural diagram of the display unit and the right diagram is a schematic structural diagram of pins of the display unit, the display unit includes four pixel units and eight pins, and the eight pins include two common pins C1 and C2, a first red common pin R12, a first blue common pin B12 and a first green common pin G12 respectively connected to the RGB trichromatic chips of the adjacent first and second pixel units, and a second red common pin R34, a second blue common pin B34 and a second green common pin G34 respectively connected to the RGB trichromatic chips of the adjacent third and fourth pixel units.

As shown in FIG. 22, in which the left diagram is a schematic structural diagram of the display unit and the right diagram is a schematic structural diagram of pins of the display units, the display unit includes four pixel units and sixteen pins, and the eight pins include fourth common pins C1 and C2, three pins R1, B1 and G1 respectively connected to the red light-emitting chip, the blue light-emitting chip and the green light-emitting chip of the first pixel unit, three pins R2, B2 and G2 respectively connected to the red light-emitting chip, the blue light-emitting chip and the green light-emitting chip of the second pixel unit, three pins R3, B3 and G3 respectively connected to the red light-emitting chip, the blue light-emitting chip and the green light-emitting chip of the third pixel unit, and three pins R4, B4 and G4 respectively connected to the red light-emitting chip, the blue light-emitting chip and the green light-emitting chip of the fourth pixel unit.

In several embodiments provided by the invention, it should be understood that the device disclosed here may be implemented in other ways. For example, the embodiments of the device described above are merely illustrative. For example, the partition of units is merely based on the logic function, and in actual implementation, the units may be partitioned in other ways, for example, multiple units or components may be combined or integrated in another system, or some features may be ignored or not implemented. In addition, mutual coupling, direct coupling or communication connection displayed or discussed here may be indirect coupling or communication connection between devices or units by means of some interfaces, or may be electrical coupling or communication connection, or coupling or communication connection in other forms.

The embodiments of the invention are described in detail above, and the principle and implementation of the invention are expounded here with several examples. The description of the above embodiments is merely used to help understand the invention and the core concept of the invention. Meanwhile, those skilled in the art may make modifications to the specific embodiments and application scope of the invention according to the concept of the invention. Thus, the contents here should not be construed as limitations of the invention.

### INDUSTRIAL APPLICABILITY

An SMD LED display device, characterized by comprising:
a substrate, wherein a display unit is arranged on the substrate, the display unit comprises at least one pixel unit, the pixel unit comprises RGB trichromatic chips, and the RGB trichromatic chips comprise a red light-emitting chip, a blue light-emitting chip and a green light-emitting chip; and an encapsulant, covering a periphery of the pixel unit; wherein a first distance from the red light-emitting chip on the pixel unit to a nearest edge of the encapsulant, a second distance from the blue light-emitting chip on the pixel unit to a nearest edge of the encapsulant, and a third distance from the green light-emitting chip on the pixel unit to a nearest edge of the encapsulant are equal.

The SMD LED display device provided by the embodiments of the invention includes a substrate, a display unit being arranged on the substrate, the display unit including at least one pixel unit, the pixel unit including RGB trichromatic chips, and the RGB trichromatic chips including a red light-emitting chip, a blue light-emitting chip and a green light-emitting chip; and a encapsulant, covering a periphery of the pixel unit for sealing the pixel unit. A first distance from the red light-emitting chip on the pixel unit to a nearest edge of the encapsulant, a second distance from the blue light-emitting chip on the pixel unit to a nearest edge of the encapsulant, and a third distance from the green light-emitting chip on the pixel unit to a nearest edge of the encapsulant are equal, such that the light-emitting angles of the chips in different colors of the RGB trichromatic chips may be kept consistent, thus reducing the color cast when a display screen is watched from the top or the bottom.

## Claims

1. An SMD LED display device, **characterized by** comprising:
a substrate, wherein a display unit is arranged on the substrate, the display unit comprises at least one pixel unit, the pixel unit comprises RGB trichromatic chips, and the RGB trichromatic chips comprise a red light-emitting chip, a blue light-emitting chip and a green light-emitting chip; and
an encapsulant, covering a periphery of the pixel unit;
wherein, a first distance from the red light-emitting chip on the pixel unit to a nearest edge of the encapsulant, a second distance from the blue light-emitting chip on the pixel unit to a nearest edge of the encapsulant, and a third distance from the green light-emitting chip on the pixel unit to a nearest edge of the encapsulant are equal.

2. The SMD LED display device according to Claim 1, **characterized in that**
the encapsulant is formed by compression molding, and the red light-emitting chip, the blue light-emitting chip and the green light-emitting chip are distributed on the substrate in an equilateral triangular configuration.

3. The SMD LED display device according to Claim 1, **characterized by** comprising multiple said display units, wherein each of the display units comprises at least one said pixel unit, and a lateral distance between the light-emitting chips with the same color on two laterally adjacent said pixel units is equal to a longitudinal distance between the light-emitting chips with the same color on two longitudinally adjacent said pixel units.

4. The SMD LED display device according to Claim 1, **characterized by** comprising multiple said display units, wherein each of the display units comprises one said pixel unit, and a lateral distance between the light-emitting chips with the same color on two laterally adjacent said display units is equal to a longitudinal distance between the light-emitting chips with the same color on two longitudinally adjacent said display units.

5. The SMD LED display device according to any one of Claims 1-4, **characterized in that** the display unit comprises one said pixel unit, the pixel unit further comprises a red anode pin, a blue anode pin, a green anode pin and a common cathode pin; or, the pixel unit further comprises a red cathode pin, a blue cathode pin, a green cathode pin and a common anode pin.

6. The SMD LED display device according to any one of Claims 1-3, **characterized in that** the display unit comprises a first pixel unit and a second pixel unit, and the display unit comprises six pins or eight pins;
a distance from a red light-emitting chip of the first pixel unit to a red light-emitting chip of the second pixel unit, a distance from a blue light-emitting chip of the first pixel unit to a blue light-emitting chip of the second pixel unit, and a distance from a green light-emitting chip of the first pixel unit to a green light-emitting chip of the second pixel unit are equal.

7. The SMD LED display device according to Claim 6, **characterized in that** a distance from one chip of the RGB trichromatic chips of the first pixel unit to a nearest first edge of the encapsulant, a distance from said chip of the first pixel unit to a nearest second edge of the encapsulant, distances from the other two chips of the RGB trichromatic chips of the first pixel unit to their respective nearest edges of the encapsulant, a distance from one chip of the RGB trichromatic chips of the second pixel unit to a nearest first edge of the encapsulant, a distance from said chip of the second pixel unit to a nearest second edge of the encapsulant, and distances from the other two chips of the RGB trichromatic chips of the second pixel unit to their respective nearest edges of the encapsulant are equal.

8. The SMD LED display device according to Claim 6, **characterized in that** the RGB trichromatic chips adopt front-side mounting, the display unit comprises six pins, and the six pins comprise two common anode pins, a red common cathode pin, a blue common cathode pin and a red common cathode pin; or,
the RGB trichromatic chips adopt front-side mounting, the display unit comprises six pins, and the six pins comprise two common cathode pins, a red common anode pin, a blue common anode pin and a green common anode pin; or,
the RGB trichromatic chips adopt front-side mounting, the display unit comprises eight pins, and the eight pins comprise two common pins, three pins respectively connected to a first red light-emitting chip, a first blue light-emitting chip and a first green light-emitting chip, and three chips respectively connected to a second red light-emitting chip, a second blue light-emitting chip and a second green light-emitting chip; and the common pins and the pins connected to the RGB trichromatic chips have opposite polarities.

9. The SMD LED display device according to Claim 6, **characterized in that** the RGB trichromatic chips adopt flip-chip mounting, the display unit comprises six pins, and the six pins comprise two common anode pins, a red common cathode pin, a blue common cathode pin and a green common cathode pin; or,
the RGB trichromatic chips adopt flip-chip mounting, the display unit comprises eight pins, and the eight pins comprise two common anode pins, a first red cathode pin connected to the red light-emitting chip of the first pixel unit, a first blue cathode pin connected to the blue light-emitting chip of the first pixel unit, a first green cathode pin connected to the green light-emitting chip of the first pixel unit, a second red cathode pin connected to the red light-emitting chip of the second pixel unit, a second blue cathode pin connected to the blue light-emitting chip of the second pixel unit, and a second green cathode pin connected to the green light-emitting chip of the second pixel unit.

10. The SMD LED display device according to any one of Claims 1-3, **characterized in that** the display unit comprises a first pixel unit, a second pixel unit, a third pixel unit and a fourth pixel unit, the first pixel unit is adjacent to the second pixel unit, the third pixel unit is adjacent to the fourth pixel unit, and the display unit comprises eight pins or sixteen pins;
a distance from a red light-emitting chip of the first pixel unit to a red light-emitting chip of the second pixel unit, a distance from a blue light-emitting chip of the first pixel unit to a blue light-emitting chip of the second pixel unit, and a distance from a green light-emitting chip of the first pixel unit to a green light-emitting chip of the second pixel unit are equal;
a distance from a red light-emitting chip of the third pixel unit to a red light-emitting chip of the fourth pixel unit, a distance from a blue light-emitting chip of the third pixel unit to a blue light-emitting chip of the fourth pixel unit, and a distance from a green light-emitting chip of the third pixel unit to a green light-emitting chip of the fourth pixel unit are equal.
